# EUROPEAN PATENT APPLICATION

(11) **EP 1 385 203 A2**
(43) Date of publication of application: **28.01.2004**
(21) Application number: 03016352.1
(22) Date of filing: 18.07.2003
(51) Int. Cl.: H01L 21/8246, H01L 27/22

(54) **Nonvolatile solid-state magnetic memory, method for controlling coercive force of nonvolatile solid-state magnetic memory, and method for recording in nonvolatile solid-state magnetic memory**

(30) Priority: 22.07.2002 JP 2002212000
(71) Applicant: Tohoku University, Sendai City, Miyagi Pref. (JP)
(72) Inventor: Ohno, Hideo, Sendai City, Miyagi Pref. (JP); Matsukura, Fumihiro, Sendai City, Miyagi Pref. (JP); Chiba, Daichi, Sendai City, Miyagi Pref. (JP)
(74) Representative: von Hellfeld, Axel, Dr. Dipl.-Phys.

(57) **Abstract**

On a given substrate are successively formed a buffer layer, a recording layer made of carrier induced ferromagnetic material, a metallic electrode layer via an insulating layer, to complete a nonvolatile solid-state magnetic memory as an electric field effect transistor. For recording, a given electric field is applied to the recording layer via the metallic electrode layer so that the hole carrier concentration can be reduced to decrease the coercive force of the recording layer and thus, perform recording operation through the magnetic inversion of the recording layer with a relatively small external magnetic field.

## Description

### BACKGROUND OF THE INVENTION

### Field of the Invention

This invention relates to a nonvolatile solid-state magnetic memory, a method for controlling the coercive force of a nonvolatile solid-state magnetic memory, and a method for recording in a nonvolatile solid-state magnetic memory.

### Description of the prior art

With a nonvolatile solid-state magnetic memory having a ferromagnetic layer as a recording layer, it is required for recording to apply a given external magnetic field to the recording layer. On the other hand, it is desired to develop the integration density of the nonvolatile solid-state magnetic memory, and in this point of view, the miniaturization for constituents of the nonvolatile solid-state magnetic memory such as the recording layer is desired.

The miniaturization causes the enhancement of the demagnetizing field in the recording layer, so that conventionally, it is required for recording in the nonvolatile solid-state magnetic memory to apply to the memory an external magnetic field large enough to invert the magnetization of the recording layer against the large demagnetizing field thereof. As a result, in recording, a large electric power consumption is required, and thus, the nonvolatile solid-state magnetic memory practically usable and of low electric power consumption was able to be provided.

### SUMMERY OF THE INVENTION

It is an object of the present invention to provide a nonvolatile solid-state magnetic memory practically usable and of low electric power consumption.

For achieving the above object, this invention relates to a nonvolatile solid-state magnetic memory including a recording layer made of carrier induced ferromagnetic material.

This invention also relates to a method for controlling the coercive force of a nonvolatile solid-state magnetic memory with a recording layer made of carrier induced ferromagnetic material, comprising the step of applying a given electric field to the recording layer so that the hole carrier concentration of the recording layer is reduced during recording.

Moreover, this invention relates to a method for recording in a nonvolatile solid-state magnetic memory with a recording layer made of carrier induced ferromagnetic material, comprising the steps of:
placing said nonvolatile solid-state magnetic memory under an external magnetic field to apply a given magnetic field of inversion to the recording layer,
   and
applying a given electric field to the recording layer under the magnetic field of inversion so that the hole carrier concentration of the recording layer can be reduced, to invert the magnetization of the recording layer and thus, perform recording operation for the nonvolatile solid-state magnetic memory.

The carrier induced ferromagnetic material is one of new ferromagnetic semiconductors, and can control the magnetic property thereof by adjusting the carrier number and the carrier spin polarization by means of light or electric field. The inventors have conceived to utilize the carrier induced ferromagnetic material as a recording layer of a nonvolatile solid-state magnetic memory. In this case, by applying to the recording layer a given electric field so as to reduce the hole carrier concentration thereof, the coercive force of the recording layer can be controlled, and by adjusting the intensity of the electric field, the coercive force of the recording layer can be reduced. Therefore, the magnetization of the recording layer can be inverted with smaller external magnetic field and thus, recording performance for the nonvolatile solid-state magnetic memory can be done.

As a result, according to the present invention, the nonvolatile solid-state magnetic memory practically usable and of low electric power consumption can be provided.

In a preferred embodiment of the present invention, the nonvolatile solid-state magnetic memory is so constructed as to control the carrier concentration of the recording layer easily. Concretely, the recording layer is formed above a substrate, and a metallic electrode layer is formed above the recording layer via an insulating layer, thereby to complete an electric field effect transistor. In this case, the recording layer functions as a channel layer, and the metallic electrode layer functions as a gate electrode. Therefore, the electric field for the reduction of the coercive force of the recording layer can be applied to the nonvolatile solid-state magnetic memory via the metallic electrode layer, and then, the recording operation for the nonvolatile solid-state magnetic memory can be simplified.

Other advantages and details of the present invention will be described below.

### BRIEF DESCRIPTION OF THE DRAWINGS

For better understanding of the present invention, reference is made to the attached drawings, wherein
Fig. 1 is a structural view showing a nonvolatile solid-state magnetic memory according to the present invention, and
Fig. 2 is a graph showing the relation between the electric field and the coercive force of the nonvolatile solid-state magnetic memory.

### DESCRIPTION OF THE PREFERRED EMBODIMENTS

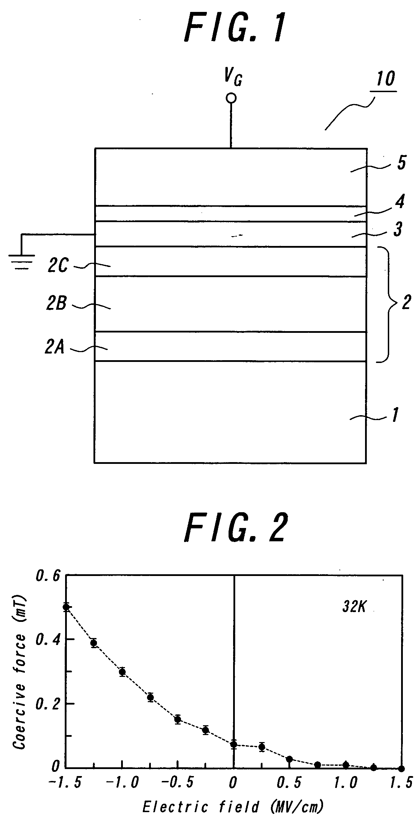

Fig. 1 is a structural view showing a nonvolatile solid-state magnetic memory according to the present invention. In the nonvolatile solid-state magnetic memory illustrated in Fig. 1, on a given substrate 1 are formed successively a buffer layer 2, a recording layer made of carrier induced ferromagnetic material, and a metallic electrode layer 5 via an insulating layer 4, thereby to complete an electric field effect transistor.

It is desired that the carrier induced ferromagnetic material forming the recording layer is ferromagnetic semiconductor such as (Ga, Mn)As or (In, Mn)As, which has excellent ferromagnetic semiconductor properties and whereby the recording operation for the nonvolatile solid-state magnetic memory according to the present invention can be performed in good condition and the recording information can be retained stably for a long time.

The thickness of the recording layer 3 is preferably set within 0.3-200nm, particularly within 3-10nm. In this case, the nonvolatile solid-state magnetic memory can be sufficiently miniaturized under the recording performance in good condition and the stable retention of the recording information.

In the case that the recording layer 3 is made of the carrier induced ferromagnetic semiconductor as mentioned above, the substrate 1 is preferably made of GaAs single crystal. In this case, the recording layer 3 can be epitaxially grown in good crystallinity, to enhance the performance of the nonvolatile solid-state magnetic memory 10.

In Fig. 1, the buffer layer 3 is constructed of a multilayered structure composed of semiconductor layers 2A-2C. In this case, the difference in lattice constant between the substrate 1 and the recording layer 3 can be compensated effectively, to enhance the epitaxial growth of the recording layer 3 and thus, develop the performance of the nonvolatile solid-state magnetic memory 10 effectively and efficiently.

The multilayered buffer layer can be preferably employed when the recording layer 3 is made of (In, Mn)As and the substrate 1 is made of (001)GaAs single crystal. Since the mismatch in lattice constant between the (In, Mn)As and the (001)GaAs single crystal is about 7%, the use of the multilayered buffer layer can compensate the mismatch in lattice constant and thus, prompt the epitaxial growth of the recording layer 3. In this case, the semiconductor layer 2A is made of AlSb layer, and the semiconductor layer 2b is made of AlGaSb layer, and the semiconductor layer 2c is made of InAs layer.

The insulating layer 4 may be made of an inorganic material such as SiO₂, SiN, Al₂O₃ or an organic material such as polyimide. The metallic electrode layer 5 may be made of conductive metallic material such as Al or Au.

Then, a recording method using the nonvolatile solid-state magnetic memory 10 will be described below. Since the nonvolatile solid-state magnetic memory 10 is so constructed as the electric field effect transistor, the metallic electrode layer 5 functions as a gate electrode and the recording layer 3 functions as a channel layer.

First of all, the nonvolatile solid-state magnetic memory 10 is placed under an external magnetic field so as to apply to the recording layer 3 a given magnetic field of inversion. Then, a given electric field is applied to the recording layer 3 via the metallic electrode layer 5 so as to reduce the hole concentration thereof. In this case, the coercive force of the recording layer 3 can be reduced, and if below the magnetic field of inversion, the magnetization of the recording layer 3 can be inverted and the recording for the recording layer 3 can be performed.

The intensity of the electric field to apply to the recording layer 3 is not restricted only if the recording performance is done, but preferably set within 0.01-10MV/cm, more preferably within 0.01-1mV/cm. In this case, irrespective of the physical properties such as thickness and the like of the recording layer 3, the coercive force of the recording layer 3 can be reduced within a range of 0.1-10mT and thus, the recording operation can be performed with a relatively small external magnetic field.

Under the range of the intensity of the electric field, the intensity of the external magnetic field is set within 0.1-10mT for recording.

### (Example)

In this Example, a nonvolatile solid-state magnetic memory as shown in Fig. 1 was fabricated. A (001)GaAs single crystal substrate was employed, and heated to 550°C. Then, an AlAs layer and an Al_{0.82}Ga_{0.18}Sb layer were successively formed in thicknesses of 50nm and 300nm, respectively on the substrate by means of MBE. Then, the substrate was cooled down to 450°C, and an InAs layer was formed in a thickness of 5nm by means of MBE, to complete a buffer layer.

Then, the substrate was cooled down to 250°C, and an (In_{0.967}Mn_{0.033})As layer as a recording layer was formed in a thickness of 4nm by means of MBE. Then, an SiO₂ insulating layer was formed in a thickness of 0.9 µm by means of spin coating, and a Cr(5nm)/Au(95nm) as a metallic electrode layer was formed by means of deposition, thereby to complete an intended nonvolatile solid-state magnetic memory.

Fig. 2 is a graph showing the relation between the electric field and the coercive force of the nonvolatile solid-state magnetic memory at a temperature of 32K when the electric field is applied to the recording layer via the metallic electrode layer. As is apparent from Fig. 2, as the electric field is increased and the hole carrier concentration is decreased, the coercive force is decreased and becomes very small within the positive electric field range. Therefore, by applying a relatively small external magnetic field as an inversion magnetic field, the magnetization of the recording layer can be inverted and thus, the recording operation can be performed.

For example, since the coercive force of the recording layer is decreased below 0.2mT at the application of the electric field with an intensity of - 0.5MV/cm or over, the magnetization of the recording layer can be inverted and thus, the recording operation can be performed by applying to the recording layer the external magnetic field with an intensity of 0.2mT. Therefore, it was turned out that the electric power consumption can be reduced remarkably.

Although the present invention was described in detail with reference to the above examples, this invention is not limited to the above disclosure and every kind of variation and modification may be made without departing from the scope of the present invention.

In the above-mentioned embodiment, for example, the nonvolatile solid-state magnetic memory is so constructed as the electric field effect transistor so that the hole carrier concentration of the recording layer is controlled by applying a given electric field thereto. However, a given protective layer is provided, instead of the metallic electrode layer 5, so that the carrier concentration of the recording layer can be controlled by irradiating an exciting light beam thereto from the outside. Moreover, the hole carrier concentration of the recording layer 3 can be controlled through the pn junction between the p-type (In, Mn)As ferromagnetic semiconductor and another n-type semiconductor joined with the ferromagnetic semiconductor.

As mentioned above, according to the present invention, a nonvolatile solid-state magnetic memory practically recorded by a relatively small external magnetic field due to the sufficiently reduced coercive force thereof can be provided.

## Claims

1. A nonvolatile solid-state magnetic memory comprising a recording layer made of carrier induced ferromagnetic material.

2. The nonvolatile solid-state magnetic memory as defined in claim 1, wherein said carrier induced ferromagnetic material is carrier induced ferromagnetic semiconductor.

3. The nonvolatile solid-state magnetic memory as defined in claim 2, wherein said carrier induced ferromagnetic semiconductor is at least one of (Ga, Mn)As and (In, Mn)As.

4. The nonvolatile solid-state magnetic memory as defined in any one of claims 1-3, wherein the carrier concentration of said recording layer is controlled.

5. The nonvolatile solid-state magnetic memory as defined in claim 4, wherein said recording layer is formed above a given substrate, and a metallic electrode layer is formed above said recording layer via an insulating layer.

6. The nonvolatile solid-state magnetic memory as defined in claim 5, wherein a given buffer layer is formed between said substrate and said recording layer.

7. The nonvolatile solid-state magnetic memory as defined in claim 5 or 6, wherein said recording layer functions as a channel layer.

8. The nonvolatile solid-state magnetic memory as defined in claim 7, wherein said metallic electrode layer functions as a gate electrode.

9. The nonvolatile solid-state magnetic memory as defined in any one of claims 1-8, wherein the thickness of said recording layer is set within 0.3-200nm.

10. The nonvolatile solid-state magnetic memory as defined in any one of claims 3-9, wherein said substrate is made of GaAs.

11. A method for controlling the coercive force of a nonvolatile solid-state magnetic memory with a recording layer made of carrier induced ferromagnetic material, comprising the step of applying a given electric field to said recording layer so that the hole carrier concentration of said recording layer is reduced during recording.

12. The controlling method of coercive force as defined in claim 11, wherein said carrier induced ferromagnetic material is carrier induced ferromagnetic semiconductor.

13. The controlling method of coercive force as defined in claim 12, wherein said carrier induced ferromagnetic semiconductor is at least one of (Ga, Mn)As and (In, Mn)As.

14. The controlling method of coercive force as defined in any one of claims 11-13, wherein the thickness of said recording layer is set within 0.3-200nm.

15. The controlling method of coercive force as defined in any one of claims 11-14, wherein the intensity of said electric field is set within 0.01-10MV/cm.

16. The controlling method of coercive force as defined in any one of claims 11-15, wherein the carrier concentration of said recording layer is controlled.

17. The controlling method of coercive force as defined in claim 16, wherein said nonvolatile solid-state magnetic memory includes a given substrate to support said recording layer and a metallic electrode layer provided above said recording layer via said insulating layer, thereby to complete an electric field effect transistor, and said recording layer functions as a channel layer and said metallic electrode layer functions as a gate electrode, whereby said electric field is applied to said recording layer via said metallic electrode layer.

18. The controlling method of coercive force as defined in claim 17, wherein said nonvolatile solid-state magnetic memory includes a buffer layer between said substrate and said recording layer.

19. The controlling method of coercive force as defined in any one of claims 13-18, wherein said substrate is made of GaAs.

20. A method for recording in a nonvolatile solid-state magnetic memory with a recording layer made of carrier induced ferromagnetic material, comprising the steps of:
placing said nonvolatile solid-state magnetic memory under an external magnetic field to apply a given magnetic field of inversion to said recording layer,
and
applying a given electric field to said recording layer under said magnetic field of inversion so that the hole carrier concentration of said recording layer can be reduced, to invert the magnetization of said recording layer and thus, perform recording operation for said nonvolatile solid-state magnetic memory.

21. The recording method of nonvolatile solid-state magnetic memory as defined in claim 20, wherein said carrier induced ferromagnetic material is carrier induced ferromagnetic semiconductor.

22. The recording method of nonvolatile solid-state magnetic memory as defined in claim 21, wherein said carrier induced ferromagnetic semiconductor is at least one of (Ga, Mn)As and (In, Mn)As.

23. The recording method of nonvolatile solid-state magnetic memory as defined in any one of claims 20-22, wherein the thickness of said recording layer is set within 0.3-200nm.

24. The recording method of nonvolatile solid-state magnetic memory as defined in any one of claims 20-23, wherein the intensity of said electric field is set within 0.01-10MV/cm.

25. The recording method of nonvolatile solid-state magnetic memory as defined in any one of claims 20-24, wherein the carrier concentration of said recording layer is controlled.

26. The recording method of nonvolatile solid-state magnetic memory as defined in claim 25, wherein said nonvolatile solid-state magnetic memory includes a given substrate to support said recording layer and a metallic electrode layer provided above said recording layer via said insulating layer, thereby to complete an electric field effect transistor, and said recording layer functions as a channel layer and said metallic electrode layer functions as a gate electrode, whereby said electric field is applied to said recording layer via said metallic electrode layer.

27. The recording method of nonvolatile solid-state magnetic memory as defined in claim 26, wherein said nonvolatile solid-state magnetic memory includes a buffer layer between said substrate and said recording layer.

28. The recording method of nonvolatile solid-state magnetic memory as defined in any one of claims 22-27, wherein said substrate is made of GaAs.

29. The recording method of nonvolatile solid-state magnetic memory as defined in any one of claims 22-28, wherein the intensity of said external magnetic field is set within 0.1-100mT.
